# EUROPEAN PATENT SPECIFICATION

(11) **EP 2 760 060 B1**
(45) Date of publication and mention of the grant of the patent: **21.04.2021**
(21) Application number: 13197627.6
(22) Date of filing: 17.12.2013
(51) Int. Cl.: H01L 51/52

(54) **Quasi-surface emission vertical-type organic light-emitting transistors and method of manufacturing the same**
Vertikale, organische Licht emittierende Transistoren mit Quasi-Oberflächenemission und Verfahren zur Herstellung davon
Transistors électroluminescents organiques de type vertical à émission en quasi-surface et son procédé de fabrication

(30) Priority: 23.01.2013 KR 20130007683
(43) Date of publication of application: 30.07.2014
(73) Proprietor: SNU R&DB Foundation, Seoul 151-742 (KR)
(72) Inventor: Lee, Sin, Doo, 156-849 Seoul (KR); Kim, Min Hoi, 134-020 Seoul (KR); Keum, Chang Min, 435-727 Gyeonggi-do (KR)
(74) Representative: Ferreccio, Rinaldo

(56) References cited:
- WO-A1-2007/080575
- US-A1- 2009 179 195
- US-A1- 2010 090 203
- US-A1- 2010 155 705

## Description

### BACKGROUND

### 1. Field

Embodiments relate to a quasi-surface emission vertical-type organic light-emitting transistor and a method of manufacturing the same.

### 2. Description of the Related Art

An organic light-emitting transistor enables to control light-emitting characteristics without an additional driving element whereas an organic light-emitting diode always needs a driving element such as a thin-film-transistor. As a result, the organic light-emitting transistor has a high aperture ratio and high light emission efficiency, and thus it is promising as a next-generation light-emitting device Organic light-emitting transistor devices and corresponding manufacturing methods are disclosed in the US patent applications published under No. US 2009/0179195 and No. US 2010/0090203 in the name of Obata et al.. Moreover, a display device including organic light-emitting transistors is also known from the US patent application published under No. US 2010/0155705 in the name of Shin et al.

Although the organic light-emitting transistor has such intrinsic merits, line-type emission characteristics are necessarily achieved in organic light-emitting transistors where a source electrode and a drain electrode are laterally located on the same plane. In other words, effective light emission is occupied only in a small region out of the entire device. In order to overcome this problem, an organic light-emitting transistor having an interdigitated electrode or a trilayer organic light-emitting transistor has been proposed. However, the increase of the light emission area by the device configuration in a simple additive manner is still limited and is not sufficient for practical applications of the organic light-emitting transistor.

As an alternative to the simple addition of the light emission area, a metal-insulator-semiconductor structure, which can be applied in a vertical-type organic light-emitting device, has been proposed. Recently, a low-voltage and low-power organic light-emitting transistor using carbon nano-tubes as a source electrode has been also proposed. Because of the random distribution and no alignment of the carbon nano-tubes in a layer used as the source electrode, the resultant surface roughness lowers the stability and the lifetime of the device. In addition, the light emission efficiency and the reproducibility are possibly deteriorated due to the poor connectivity and the spatial non-uniformity inherent to an assembled structure of carbon nano-tubes.

### SUMMARY

The present disclosure is directed to providing a new organic light-emitting transistor having a large light emission area, and a cost-effective technique for combining a light-emitting element and a driving transistor. This organic light-emitting transistor can be used for next-generation displays and various optoelectronic devices beyond the organic light-emitting diode.

An organic light-emitting transistor according to an embodiment may include a gate electrode; a gate insulation layer formed on the gate electrode; a mesh-type source electrode having a plurality of apertures in an array pattern, formed on the gate insulation layer; a source insulator located on the mesh-type source electrode and having patterns; a semiconductor layer located on the gate insulation layer and on sidewalls of both the mesh-type source electrode and the source insulator and upper surface of the source insulator; and an organic light-emitting layer located on the semiconductor layer, wherein the plurality of apertures are formed by using the source insulator as an etching mask so that the sidewalls of the mesh-type source electrode are vertically aligned with the sidewalls of the source insulator.

The organic light-emitting transistor may further include the drain electrode. The mesh-type source electrode may be located between the gate electrode and the drain electrode. The organic light-emitting transistor may include the semiconductor layer and the organic light emitting layer located between the mesh-type source electrode and the drain electrode.

In the organic light-emitting transistor, the drain electrode and/or the gate electrode may include a plurality of apertures in an array pattern.

In the organic light-emitting transistor, each of the plurality of apertures may have a circular, oval, or polygonal shape. Each of the plurality of apertures may have a width of 200 µm or below, and a gap between two neighboring apertures in the plurality of apertures may be 200 µm or below.

In the organic light-emitting transistor, the plurality of apertures may be formed as a plurality of holes or a plurality of strips. For example, the plurality of apertures may be formed through the mesh-type source electrode and may be formed as a plurality of holes in a two-dimensional array. Alternatively, the plurality of apertures may extend from one side of the mesh-type source electrode to the other side of the mesh-type electrode and may be formed as a plurality of strips in one-dimensional array.

A method of manufacturing an organic light-emitting transistor according to an embodiment may include: forming a gate electrode; forming a gate insulation layer on the gate electrode; forming an electrode layer; forming a source insulator with patterns on the electrode layer; patterning the electrode layer by using the source insulator as an etching mask to form a mesh-type source electrode having a plurality of apertures in an array pattern, wherein sidewalls of the mesh-type source electrode are vertically aligned with sidewalls of the source insulator; forming a semiconductor layer on the gate insulation layer and on the sidewalls of both the mesh-type source electrode and the source insulator and upper surface of the source insulator; and forming an organic light-emitting layer on the semiconductor layer.

In addition, the method of manufacturing an organic light-emitting transistor may further include: forming a drain electrode on the organic light-emitting layer.

In the method of manufacturing an organic light-emitting transistor, said patterning of the electrode layer may include: forming a source insulator on the electrode layer, wherein the source insulator is made of a photoresist; irradiating ultraviolet rays to a predetermined area of the source insulator made of photoresist; removing the region irradiated by ultraviolet rays from the source insulator made of photoresist; and etching the electrode layer by using the source insulator as an etching mask.

In the method of manufacturing an organic light-emitting transistor, each of the plurality of apertures may have a circular, oval, or polygonal shape. Each of the plurality of apertures may have a width of 200 µm or below, and a gap between two neighboring apertures in the plurality of apertures may be 200 µm or below.

In the method of manufacturing an organic light-emitting transistor, the plurality of apertures is formed as a plurality of holes or a plurality of strips. For example, the plurality of apertures may be formed through the mesh-type source electrode and may be formed as a plurality of holes in a two-dimensional array. Alternatively, the plurality of apertures may extend from one side of the mesh-type source electrode to the other side of the mesh-type electrode and may be formed as a plurality of strips in one-dimensional array.

The organic light-emitting transistor according to an aspect of the present disclosure shows quasi-surface emission characteristics acquired by the employment of a mesh-type source electrode. The organic light-emitting transistor with a mesh-type source electrode may produce a surface emission level similar to that of the organic light-emitting diode. Moreover, an aperture ratio, brightness, and light emission efficiency of the organic light-emitting transistor may be superior to those of an organic light-emitting diode. Another advantage is that the production cost may be reduced since an additional driving element such as a thin-film-transistor is not needed.

The manufacturing methods according to an aspect of the present disclosure can be easily realized by conventional lithographic or ink-jet printing processes of fabricating the electrode and the semiconductor, and may be applicable for new organic optoelectronic devices and flexible displays.

### BRIEF DESCRIPTION OF THE DRAWINGS

The above and other aspects, features and advantages of the disclosed exemplary embodiments will be more apparent from the following detailed description taken in conjunction with the accompanying drawings in which:
FIG. 1a is a cross-sectional view showing a quasi-surface emission vertical-type organic light-emitting transistor according to an embodiment;
FIG. 1b is a plane view showing a mesh-type source electrode of the organic light-emitting transistor depicted in FIG. 1a;
FIGS. 2a and 2b are diagrams showing injection and flow of charges toward an aperture from the boundary of a source electrode of the organic light-emitting transistor according to embodiments;
FIGS. 3a to 3e are cross-sectional views illustrating a fabrication process of a mesh-type source electrode for manufacturing an organic light-emitting transistor according to an embodiment;
FIGS. 4a and 4b are optical microscopic photographs showing a mesh-type source electrode fabricated according to embodiments;
FIGS. 5a to 5c are optical microscopic photographs showing quasi-surface emission in the organic light-emitting transistor by applying a voltage between a gate electrode and a source electrode;
FIG. 5d is a graph showing the spatial distribution of brightness in FIGS. 5a to 5c;
FIGS. 6a to 6c are optical microscopic photographs showing quasi-surface emission in the organic light-emitting transistor by applying a voltage between a source electrode and a drain electrode; and
FIG. 6d is a graph showing the spatial distribution of brightness in FIG. 6c.

### DETAILED DESCRIPTION

Hereinafter, embodiments of the present disclosure will be described in detail with reference to the accompanying drawings.

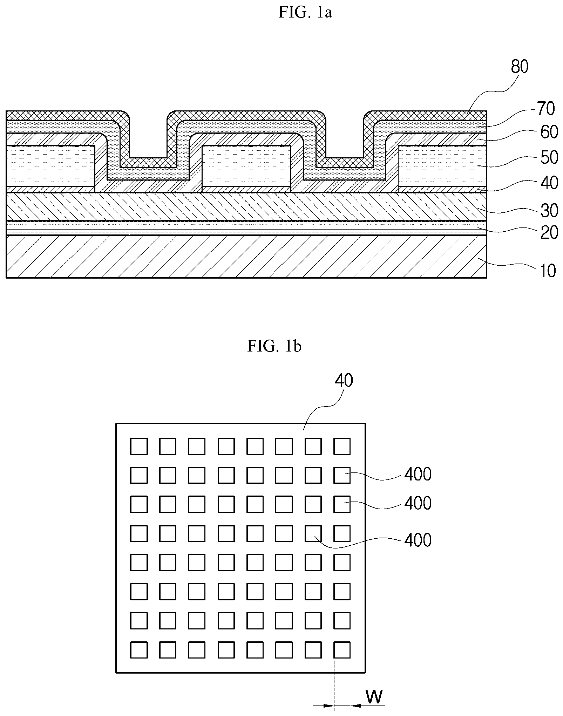

FIG. 1a is a cross-sectional view showing an organic light-emitting transistor according to an embodiment, and FIG. 1b is a plane view showing a mesh-type source electrode of the organic light-emitting transistor depicted in FIG. 1a. The organic light-emitting transistor according to embodiments may be a vertical-type organic light-emitting transistor where the light emission is generated by vertical movement of charges and has quasi-surface emission characteristics due to a large light emission area.

Referring to FIGS. 1a and 1b, the organic light-emitting transistor according to an embodiment includes a mesh-type source electrode 40. The mesh-type source electrode 40 has a plurality of apertures 400 arranged in an array pattern. Each aperture 400 may be formed through the source electrode 40. In an embodiment, the shape of each aperture 400 may be a hole formed within the source electrode 40 when the source electrode 40 is viewed from the above. In another embodiment, the shape of each aperture 400 may be a strip extending from the one side of the source electrode 40 to the other side of the source electrode 40 when the source electrode 40 is viewed from the above. The hole or strip forming the aperture 400 may have a cross-sectional shape such as a circle, an oval or a polygon.

Furthermore, the organic light-emitting transistor includes a substrate 10, a gate electrode 20, and a gate insulator 30 below the mesh-type source electrode 40. Above the mesh-type source electrode 40, a source insulator 50. a semiconductor layer 60, an organic light emitting layer 70, and a drain electrode 80 are included. In an embodiment, the source insulator 50 is made of a photoresist (PR). The mesh-type source electrode 40 may be located between the drain electrode 80 in the top and the gate electrode 20 in the bottom.

The substrate 10 supports the entire structure of the organic light-emitting transistor. The substrate 10 may be made of glass, quartz, polymer resin (for example, plastic or the like), silicon, or other suitable materials.

The gate electrode 20 may be formed on the substrate 10. The gate electrode 20 may be made of an electrically-conductive transparent material (for example, indium-tin-oxide), a metal such as aluminum (Al), gold (Au), silver (Ag) or the like, a conductive organic material, a nonmetallic material such as a conductive polymer or an assembly of conductive particles, or other suitable conductive material. The gate electrode 20 may be formed by vacuum deposition, without being limited thereto.

The gate insulator 30 is formed on the gate electrode 20. The gate insulator 30 may be made of an electrically-insulating inorganic material such as silicon oxide (SiO₂), an organic material such as an insulating polymer, or other suitable material having properties to block the electric current and to apply an electric field at the gate electrode 20 to the semiconductor layer 60 for the charge transport.

The mesh-type source electrode 40 is formed on the gate insulator 30. The source electrode 40 may be made of a material which has excellent electric conductivity, facilitates the charge injection to the semiconductor layer 60, and is capable of being patterned. For example, the source electrode 40 may be made of a metal such as gold (Au), a nonmetallic material such as a conductive organic material or an assembly of conductive particles, or other suitable conductive material. The source electrode 40 may be formed by vacuum-deposition and patterned by photolithography, without being limited thereto.

In an embodiment, the source insulator 50, made of the photoresist, on the source electrode 40 is used to pattern the source electrode 40. If no insulator is present on the source electrode 40, charges are injected and transported by the voltage difference between the source electrode 40 and the drain electrode 80 irrespective of the gate voltage. This causes light emission similar to the organic light-emitting diode, meaning that the switching function of the driving transistor disappears.

The semiconductor layer 60 is formed on the gate insulator 30 in the apertures 400 and on the source insulator 50. The semiconductor layer 60 may be made of a low-molecular organic semiconductor or a polymeric semiconductor material, an inorganic semiconductor material, or other suitable material capable of forming a charge transporting channel under a voltage. In addition, the semiconductor layer 60 may be made of a material containing metal particles to the above material. In an embodiment, the semiconductor layer 60 may be made of pentacene having the p-type semiconducting properties, without being limited thereto.

The organic light-emitting layer 70 is formed on the semiconductor layer 60 The organic light-emitting layer 70 may be configured into a single layer structure composed of a p-type semiconductor together with an n-type semiconductor, an ambipolar semiconductor material, or the like. A bilayer or trilayer structure can be also used for improving light emission efficiency or controlling light color. In an embodiment, the organic light-emitting layer 70 may be configured with a bilayer of α-NPD (N,N'-di(1-naphthyl)-N,N'-diphenylbenzidine) and Alq3 ((tri-(8-hydroxyquinoline)aluminum) prepared by vacuum deposition, without being limited thereto.

The drain electrode 80 may be formed on the organic light-emitting layer 70. The drain electrode 80 may be made of a metallic or nonmetallic material, which has excellent electric conductivity and facilitates the charge injection to the semiconductor layer 60, similar to the source electrode 40. In an embodiment, the drain electrode 80 may be configured as a bilayer of lithium fluoride (LiF) and aluminum (Al), without being limited thereto.

In the organic light-emitting transistor as described above according to this embodiment, the source electrode 40 is formed in a mesh type with the plurality of apertures 400 which leads directly to the enhancement of the charge injection and transport through the semiconductor layer 60 toward the organic light-emitting layer 70. As a result, the effective emission of the organic light-emitting layer 70 exhibits quasi-surface emission characteristics that can vary with a gate voltage.

Specifically, charges are injected into the semiconductor layer 60 through the aperture 400 of the source electrode 40, and mobile charges are recombined with charges having the opposite polarity present in the organic light-emitting layer 70. Charge injection to the semiconductor layer 60, charge recombination in the organic light-emitting layer 70, and the resultant light emission area and brightness are primarily influenced by the physical dimension of the aperture 400. The light emission characteristics of the organic light-emitting transistor can be optimized by adjusting the shape and the size of each aperture 400 in addition to the gap between the neighboring apertures 400 in the mesh-type source electrode 40.

In an embodiment, the mesh-type source electrode 40 may include the plurality of square apertures 400. Here, each aperture 400 may have a width (W) of several nanometers to about 200 µm in each side. In addition, a gap between the neighboring apertures 400 (i.e., a line width of the source electrode 40) may be several nanometers to about 200 µm. This is just one of the examples. It should be emphasized that the shape and the size of each aperture 400 and the structural arrangement of the apertures 400 in the source electrode 40 are not limited to the above.

In a conventional vertical-type organic light-emitting transistor, the gate electrode is located between a source electrode and a drain electrode, and a charge flow between the source and the drain is adjusted by a gate voltage. In this case, the leakage current at the gate electrode is considerably large. In contrast, in the vertical-type organic light-emitting transistor of this embodiment, the source electrode 40 is located between the drain electrode 80 and the gate electrode 20, which may reduce the leakage current. The key feature of the mesh-type source electrode 40 is that an electric field generated from the gate electrode 20 should penetrate through the apertures 400 of the source electrode 40 to effectively control the charge injection and transport by a gate voltage between the source electrode 40 and the drain electrode 80.

In another embodiment, the organic light-emitting transistor may also be configured such that the gate electrode and/or the drain electrode have the plurality of the apertures. For example, the plurality of holes arranged two-dimensionally or the plurality of strip-type apertures arranged one-dimensionally may be formed in the gate electrode and/or the drain electrode. Besides the mesh-type source electrode, the spatial distribution of the electric field lines can be varied with the geometrical parameters of the gate and/or drain electrodes with the apertures for the optimization of the charge injection and transport, the charge recombination, and the resultant light emission in the organic light-emitting transistor.

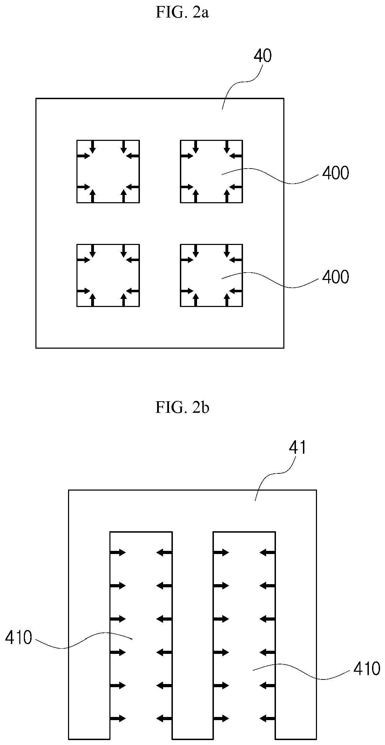

FIGS. 2a and 2b are diagrams showing injection and flow of charges in each aperture of a source electrode of the organic light-emitting transistor according to embodiments. Arrows depicted in FIGS. 2a and 2b represent a charge flow direction in the apertures 400, 410 of the source electrodes 40, 41, respectively.

Referring to FIG. 2a, in an embodiment, the source electrode 40 includes the plurality of apertures 400 in a closed configuration. The apertures 400 may be formed as the plurality of holes in a two-dimensional array within the source electrode 40. In the source electrode 40 depicted in FIG. 2a, the charge injection and flow occur in a two-dimensional manner due to the closed boundary of the aperture 400, and consequently, the recombination zone of the charges in the organic light-emitting layer 70 is expanded to cover the aperture 400. This results in quasi-surface emission, high light emission efficiency, and high brightness.

Referring to FIG. 2b, in another embodiment, the source electrode 41 includes the plurality of apertures 410 in an opened configuration. The apertures 410 may be formed as a plurality of strips extending from the one side of the source electrode 41 to the other side of the source electrode 41 when the source electrode 41 is viewed from the above. The plurality of strips may be formed in a one-dimensional array pattern. In this case, an electrode portion of the source electrode 41 has a structure similar to comb teeth. In the source electrode 41 shown in FIG. 2b, the charge injection and flow occur in a one-dimensional manner due to the open configuration of the apertures 410, which causes relatively small light emission area and low efficiency compared to the mesh-type structure depicted in FIG. 2a.

However, the shapes of the source electrodes 40, 41 and the apertures 400, 410 depicted in FIGS. 2a and 2b are just examples, and the shape, the arrangement and size of apertures formed in an electrode of the organic light-emitting transistor are not limited to FIGS. 2a and 2b. For instance, each aperture may have a cross-sectional shape of a circle, an oval, or a polygon. In addition, the term "mesh-type electrode" used in the present disclosure is intended to include all cases in which the apertures formed in the electrode have a two-dimensionally closed or a one-dimensionally open configuration, and is not intended to limit the apertures to specific locations, shapes or arrangements.

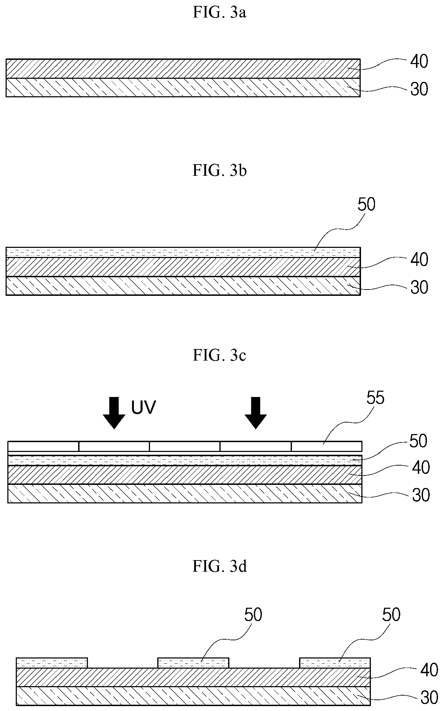

FIGS. 3a to 3e are cross-sectional views for illustrating a process of fabricating a mesh-type source electrode in manufacturing an organic light-emitting transistor according to an embodiment.

Referring to FIG. 3a, first, a gate insulator 30 may be prepared. A gate electrode (not shown) may be formed on a substrate (not shown) made of glass or plastic, and a gate insulator 30 is formed on the gate electrode. Next, a source electrode 40 is formed on the gate insulator 30. Here, the source electrode 40 may be a single film formed on the entire gate insulator 30. For example, a layer of gold (Au) may be formed on the entire surface of the gate insulator 30 by vacuum deposition as the source electrode 40, without being limited thereto.

Referring to FIG. 3b, a source insulator 50 is formed on the source electrode 40. The source insulator 50, made of the photoresist in this embodiment, may be served to pattern the source electrode 40 having apertures. The source insulator 50 may be prepared by spin-coating, without being limited thereto.

Referring to FIG. 3c, a photomask 55 may be located on the source insulator 50 made of the photoresist, and ultraviolet rays (UV) may be irradiated above the photomask 55. The photomask 55 may be prepared to have a pattern corresponding to the shape of the plurality of apertures which is to be formed in the source electrode 40. After irradiating ultraviolet rays, the photomask 55 may be removed.

Referring to FIG. 3d, the region of the source insulator 50 made of the photoresist onto which ultraviolet rays are irradiated may be removed using a photoresist developer. Accordingly, patterns corresponding to the photomask 55 are formed in the source insulator 50, and the portion of the source electrode 40 in the regions where the photoresist was developed may not be covered with the source insulator 50.

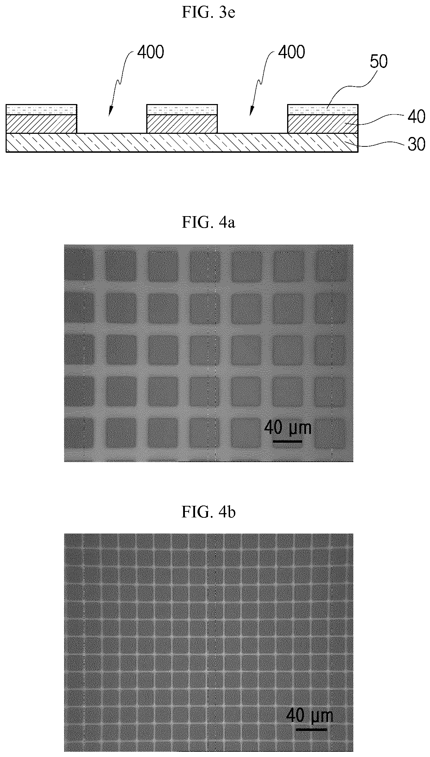

Referring to FIG. 3e, a mesh-type source electrode 40 having the plurality of apertures 400 is formed by using the source insulator 50 as an etching mask. For example, the source electrode 40 may be etched by plasma etching, without being limited thereto. Then, a semiconductor layer (not shown), an organic light-emitting layer (not shown), and a drain electrode (not shown) are sequentially formed on the gate insulator 30 through the apertures 400 and on the source insulator 50. In the organic light-emitting transistor manufactured according to the method of this embodiment, since the source electrode 40 is formed prior to the process of forming a semiconductor layer and an organic light-emitting layer, the damage of an organic material layer by a solution process or an etching process is basically avoided.

FIGS. 4a and 4b are optical microscopic photographs showing a mesh-type source electrode prepared according to the processes depicted in FIG. 3. The arrangements, the shapes, and the sizes of the electrode regions together with the apertures in the mesh-type source electrode may be adjusted with varying the patterns of the photomask. Since the organic light-emitting layer emits light through the apertures, hereinafter, an electrode region of the mesh-type source electrode will be referred to the region covered with the electrode, and the aperture region will be referred to a light emission region. FIG. 4a shows a fabricated mesh-type source electrode in which the electrode region has a width of about 20 µm and the light emission region has a width of about 40 µm. FIG. 4b shows a mesh-type source electrode in which the electrode region has a width of about 5 µm and the light emission region has a width of about 20 µm. The charge transport and flow in the semiconductor layer may be controlled by adjusting the relative size of the electrode region to the light emission region so that the light emission characteristics of the organic light-emitting layer are optimized.

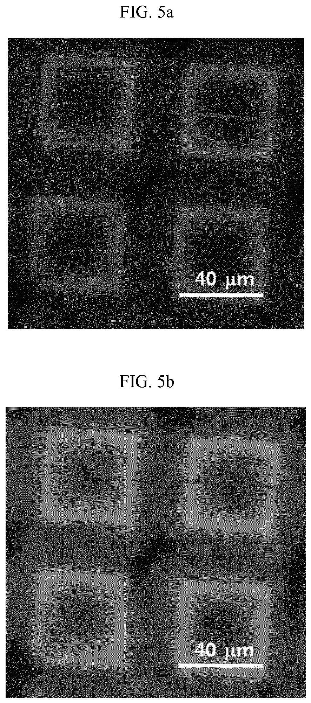

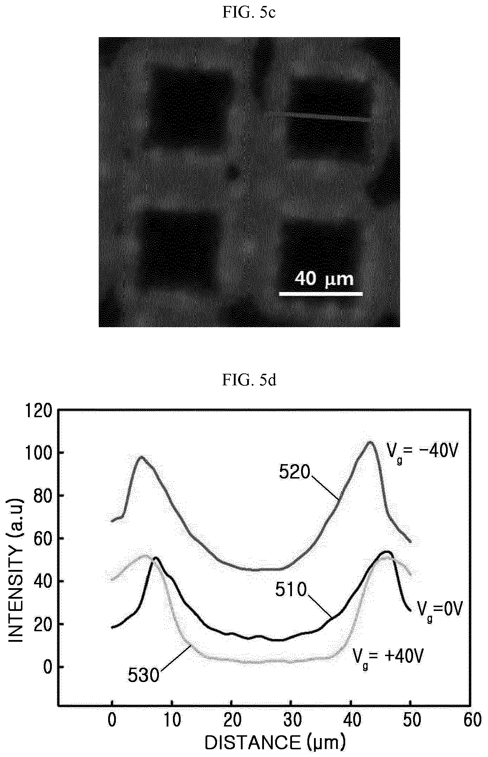

FIGS. 5a to 5c are photographs showing quasi-surface emission at the organic light-emitting transistor depending on the voltage between the gate electrode and the source electrode. FIG. 5d is a graph showing the spatial distribution of brightness in FIGS. 5a to 5c.

FIGS. 5a to 5c show quasi-surface emission of the organic light-emitting transistor when the voltages applied between the gate electrode and the source electrode are 0 V, -40 V, and +40 V, respectively. Here, a mesh-type source electrode in which each aperture has a width of about 40 µm and a gap between two neighboring apertures (i.e., a line width of the electrode region) is about 20 µm. In this embodiment, a semiconductor layer of pentacene, having the p-type semiconducting properties, is used. Three graphs 510, 520, 530 depicted in FIG. 5d represent the spatial distributions of brightness in a region (depicted with a line) across a single aperture in FIGS. 5a to 5c, respectively.

Referring to FIG. 5c, when the voltage between the gate electrode and the source electrode is +40 V, the charges in the semiconductor layer are not accumulated in the channel region and essentially no charge transport occurs. Thus, no light emission is produced.

Referring to FIG. 5a, when the voltage between the gate electrode and the source electrode is 0 V, the charges are partially transported so that light is emitted only in the small region along the perimeter of each aperture. Referring to FIG. 5b, when the voltage between the gate electrode and the source electrode is -40 V, a channel is formed and the charge transport occurs in the semiconductor layer. In addition to the charge transport in the plane of the semiconductor layer, the out-of-plane charge transport through the apertures is promoted by the voltage difference between the source electrode and the drain electrode. This results in the recombination of the mobile charges with the charges having the opposite polarity in the organic light-emitting layer. Note that for the case of the aperture having a width of about 40 µm, the in-plane charge transport is still limited and light emission over the entire aperture is not obtained.

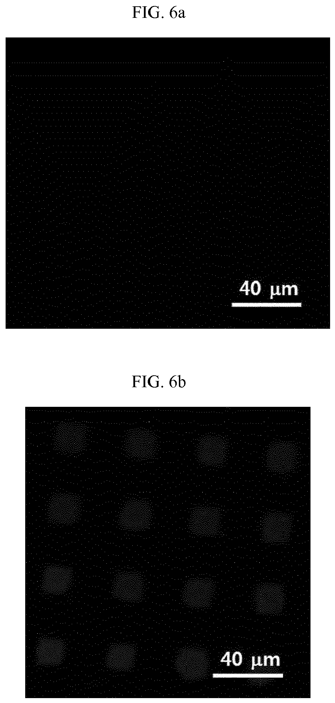

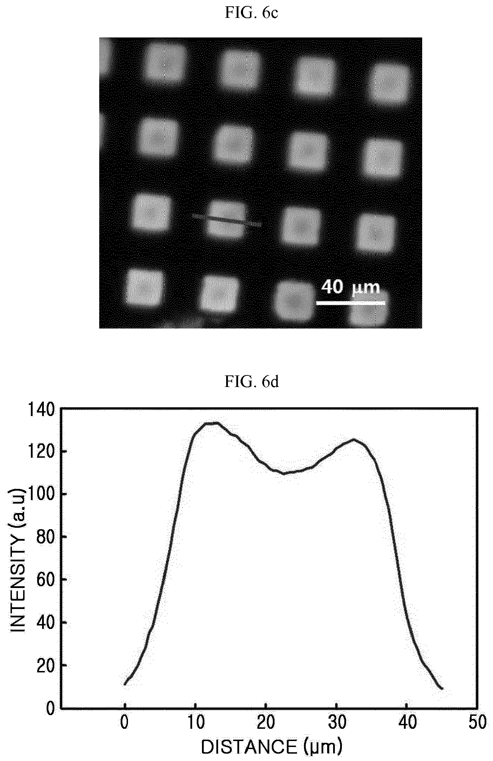

FIGS. 6a to 6c are photographs showing quasi-surface emission in the organic light-emitting transistor depending on the voltage between a source electrode and a drain electrode. FIG. 6d is a graph showing the spatial distribution of brightness in FIG. 6c.

FIGS. 6a to 6c show quasi-surface emission of the organic light-emitting transistor when the voltages applied between the drain electrode and the source electrode are 0 V, -5 V and -8.5 V, respectively. Here, a mesh-type source electrode in which each aperture has a width of about 20 µm and a gap between two neighboring apertures (i.e., a line width of the electrode region) is about 20 µm. In this embodiment, a semiconductor layer of pentacene, having the p-type semiconducting properties, is used. The graph depicted in FIG. 6d shows the spatial distribution of brightness in a region (depicted with a line) across a single aperture in FIG. 6c.

When the width of the aperture in the mesh-type source electrode is reduced from about 40 µm to about 20 µm as shown in FIG. 5 and FIG. 6, respectively, the charge transport occurs through nearly the entire aperture. In this case, quasi-surface light emission covering nearly the entire aperture is produced. From the spatial distribution of brightness depicted in FIG. 6d, the distance of the in-plane charge transport is estimated to be about 10 µm.

The organic light-emitting transistor according to the embodiments described above shows quasi-surface emission characteristics acquired by the employment of a mesh-type source electrode. The organic light-emitting transistor adopting a mesh-type source electrode may produce a surface emission level similar to that of the organic light-emitting diode. Moreover, an aperture ratio, brightness, and light emission efficiency of the organic light-emitting transistor may be superior to those of an organic light-emitting diode. Another advantage is that the production cost may be reduced since an additional driving element such as a thin-film-transistor is not needed.

The manufacturing methods according to the aspect of the present disclosure can be easily realized by conventional lithographic or ink-jet printing processes of fabricating the electrode and the semiconductor, and may be applicable for new organic optoelectronic devices and flexible displays.

While the present disclosure has been described with reference to embodiments depicted in the drawings, they are just examples, and it will be understood by those skilled in the art that various changes and modifications may be made thereto. However, such changes and modification should be interpreted as being included in the scope of the present disclosure. Therefore, the sincere scope of the present disclosure should be defined by the appended claims.

## Claims

1. An organic light-emitting transistor comprising:
a gate electrode (20);
a gate insulation layer (30) formed on the gate electrode (20);
a mesh-type source electrode (40) having a plurality of apertures (400) in an array pattern, formed on the gate insulation layer (30);
a source insulator (50) located on the mesh-type source electrode (40) and having patterns;
a semiconductor layer (60) located on the gate insulation layer (30) and on sidewalls of both the mesh-type source electrode (40) and the source insulator (50) and upper surface of the source insulator (50); and
an organic light-emitting layer (70) located on the semiconductor layer (60),
wherein the plurality of apertures (400) are formed by using the source insulator (50) as an etching mask so that the sidewalls of the mesh-type source electrode (40) are vertically aligned with the sidewalls of the source insulator (50).

2. The organic light-emitting transistor according to claim 1, further comprising a drain electrode (80),
wherein the mesh-type source electrode (40) is located between the gate electrode (20) and the drain electrode (80).

3. The organic light-emitting transistor according to claim 2,
wherein the semiconductor layer (60) and the organic light emitting layer (70) are located between the mesh-type source electrode (40) and the drain electrode (80).

4. The organic light-emitting transistor according to claim 2, wherein the drain electrode (80) comprises a plurality of apertures in an array pattern.

5. The organic light-emitting transistor according to claim 2, wherein the gate electrode (20) comprises a plurality of apertures in an array pattern.

6. The organic light-emitting transistor according to claim 1, wherein each of the plurality of apertures (400) has a width of 200 µm or below, and wherein a gap between two neighboring apertures in the plurality of apertures (400) is 200 µm or below.

7. The organic light-emitting transistor according to claim 1, wherein the plurality of apertures (400) is formed as a plurality of holes or a plurality of strips.

8. A method of manufacturing an organic light-emitting transistor, the method comprising:
forming a gate electrode (20);
forming a gate insulation layer (30) on the gate electrode (20);
forming an electrode layer;
forming a source insulator (50) with patterns on the electrode layer;
patterning the electrode layer by using the source insulator (50) as an etching mask to form a mesh-type source electrode (40) having a plurality of apertures (400) in an array pattern, wherein sidewalls of the mesh-type source electrode (40) are vertically aligned with sidewalls of the source insulator (50);
forming a semiconductor layer (60) on the gate insulation layer (30) and on the sidewalls of both the mesh-type source electrode (40) and the source insulator (50) and upper surface of the source insulator (50); and
forming an organic light-emitting layer (70) on the semiconductor layer (60).

9. The method of manufacturing an organic light-emitting transistor according to claim 8, further comprising:
forming a drain electrode (80) on the organic light-emitting layer (70).

10. The method of manufacturing an organic light-emitting transistor according to claim 8, wherein the source insulator (50) is made of a photoresist; and
wherein said forming a source insulator (50) comprises:
forming a photoresist layer on the electrode layer
irradiating ultraviolet rays to a predetermined area of the photoresist layer;
and
removing the region irradiated by ultraviolet rays from the photoresist layer to form the source insulator (50) with patterns.

11. The method of manufacturing an organic light-emitting transistor according to claim 8, wherein each of the plurality of apertures (400) has a width of 200 µm or below, and wherein a gap between two neighboring apertures in the plurality of apertures (400) is 200 µm or below.

12. The method of manufacturing an organic light-emitting transistor according to claim 8, wherein the plurality of apertures (400) is formed as a plurality of holes or a plurality of strips.

## Patentansprüche

1. Organischer lichtemittierender Transistor, umfassend:
eine Gate-Elektrode (20);
eine Gate-Isolationsschicht (30), die auf der Gate-Elektrode (20) ausgebildet ist;
eine gitterartige Source-Elektrode (40) mit einer Vielzahl von Öffnungen (400) in einem Array-Muster, die auf der Gate-Isolationsschicht (30) ausgebildet ist;
einen Source-Isolator (50), der auf der gitterartigen Source-Elektrode (40) angeordnet ist und Muster aufweist;
eine Halbleiterschicht (60), die auf der Gate-Isolationsschicht (30) und auf Seitenwänden sowohl der gitterartigen Source-Elektrode (40) als auch des Source-Isolators (50) und der oberen Oberfläche des Source-Isolators (50) angeordnet ist; und
eine organische lichtemittierende Schicht (70), die auf der Halbleiterschicht (60) angeordnet ist,
wobei die Vielzahl von Öffnungen (400) unter Verwendung des Source-Isolators (50) als eine Ätzmaske ausgebildet werden, so dass die Seitenwände der gitterartigen Source-Elektrode (40) vertikal mit den Seitenwänden des Source-Isolators (50) ausgerichtet sind.

2. Organischer lichtemittierender Transistor nach Anspruch 1, ferner umfassend eine Drain-Elektrode (80),
wobei die gitterartige Source-Elektrode (40) zwischen der Gate-Elektrode (20) und der Drain-Elektrode (80) angeordnet ist.

3. Organischer lichtemittierender Transistor nach Anspruch 2, wobei die Halbleiterschicht (60) und die organische lichtemittierende Schicht (70) zwischen der gitterartigen Source-Elektrode (40) und der Drain-Elektrode (80) angeordnet sind.

4. Organischer lichtemittierender Transistor nach Anspruch 2, wobei die Drain-Elektrode (80) eine Vielzahl von Öffnungen in einem Array-Muster umfasst.

5. Organischer lichtemittierender Transistor nach Anspruch 2, wobei die Gate-Elektrode (20) eine Vielzahl von Öffnungen in einem Array-Muster umfasst.

6. Organischer lichtemittierender Transistor nach Anspruch 1, wobei jede der Vielzahl von Öffnungen (400) eine Breite von 200 µm oder weniger aufweist, und wobei ein Spalt zwischen zwei benachbarten Öffnungen in der Vielzahl von Öffnungen (400) 200 µm oder weniger beträgt.

7. Organischer lichtemittierender Transistor nach Anspruch 1, wobei die Vielzahl von Öffnungen (400) als eine Vielzahl von Löchern oder eine Vielzahl von Streifen ausgebildet ist.

8. Verfahren zum Herstellen eines organischen lichtemittierenden Transistors, wobei das Verfahren umfasst:
Ausbilden einer Gate-Elektrode (20);
Ausbilden einer Gate-Isolationsschicht (30) auf der Gate-Elektrode (20);
Ausbilden einer Elektrodenschicht;
Ausbilden eines Source-Isolators (50) mit Mustern auf der Elektrodenschicht;
Strukturieren der Elektrodenschicht unter Verwendung des Source-Isolators (50) als eine Ätzmaske, um eine gitterartige Source-Elektrode (40) mit einer Vielzahl von Öffnungen (400) in einem Array-Muster auszubilden, wobei Seitenwände der gitterartigen Source-Elektrode (40) vertikal mit Seitenwänden des Source-Isolators (50) ausgerichtet sind;
Ausbilden einer Halbleiterschicht (60) auf der Gate-Isolationsschicht (30) und auf den Seitenwänden sowohl der gitterartigen Source-Elektrode (40) als auch des Source-Isolators (50) und der oberen Oberfläche des Source-Isolators (50); und
Ausbilden einer organischen lichtemittierenden Schicht (70) auf der Halbleiterschicht (60).

9. Verfahren zum Herstellen eines organischen lichtemittierenden Transistors nach Anspruch 8, ferner umfassend:
Ausbilden einer Drain-Elektrode (80) auf der organischen lichtemittierenden Schicht (70).

10. Verfahren zum Herstellen eines organischen lichtemittierenden Transistors nach Anspruch 8, wobei der Source-Isolator (50) aus einem Photoresist hergestellt ist; und
wobei das Ausbilden eines Source-Isolators (50) umfasst:
Ausbilden einer Photoresistschicht auf der Elektrodenschicht
Bestrahlen eines vorgegebenen Bereichs der Photoresistschicht mit ultravioletten Strahlen; und
Entfernen des durch ultraviolette Strahlen bestrahlten Bereichs von der Photoresistschicht, um den Source-Isolator (50) mit Mustern auszubilden.

11. Verfahren zum Herstellen eines organischen lichtemittierenden Transistors nach Anspruch 8, wobei jede der Vielzahl von Öffnungen (400) eine Breite von 200 µm oder weniger aufweist, und wobei ein Spalt zwischen zwei benachbarten Öffnungen in der Vielzahl von Öffnungen (400) 200 µm oder weniger beträgt.

12. Verfahren zum Herstellen eines organischen lichtemittierenden Transistors nach Anspruch 8, wobei die Vielzahl von Öffnungen (400) als eine Vielzahl von Löchern oder eine Vielzahl von Streifen ausgebildet ist.

## Revendications

1. Transistor électroluminescent organique comprenant :
une électrode de grille (20) ;
une couche d'isolation de grille (30) formée sur l'électrode de grille (20) ;
une électrode de source de type maillé (40) comportant une pluralité d'ouvertures (400) en un motif de réseau, formée sur la couche d'isolation de grille (30) ;
un isolant de source (50) situé sur l'électrode de source de type maillé (40) et présentant des motifs ;
une couche semi-conductrice (60) située sur la couche d'isolation de grille (30) et sur des parois latérales de l'électrode de source de type maillé (40) et de l'isolant de grille (50) et une surface supérieure de l'isolant de source (50) ; et
une couche électroluminescente organique (70) située sur la couche semi-conductrice (60),
dans lequel la pluralité d'ouvertures (400) sont formées en utilisant l'isolant de source (50) comme masque de gravure de telle sorte que les parois latérales de l'électrode de source de type maillé (40) sont verticalement alignées sur les parois latérales de l'isolant de source (50).

2. Transistor électroluminescent organique selon la revendication 1, comprenant
en outre une électrode de drain (80),
dans lequel l'électrode de source de type maillé (40) est située entre l'électrode de grille (20) et l'électrode de drain (80).

3. Transistor électroluminescent organique selon la revendication 2,
dans lequel la couche semi-conductrice (60) et la couche électroluminescente organique (70) sont situées entre l'électrode de source de type maillé (40) et l'électrode de drain (80).

4. Transistor électroluminescent organique selon la revendication 2, dans lequel l'électrode de drain (80) comprend une pluralité d'ouvertures selon un motif de réseau.

5. Transistor électroluminescent organique selon la revendication 2, dans lequel l'électrode de grille (20) comprend une pluralité d'ouvertures selon un motif de réseau.

6. Transistor électroluminescent organique selon la revendication 1, dans lequel chacune de la pluralité d'ouvertures (400) présente une largeur de 200 µm ou moins, et dans lequel un espace entre deux ouvertures voisines de la pluralité d'ouvertures (400) fait 200 µm ou moins.

7. Transistor électroluminescent organique selon la revendication 1, dans lequel la pluralité d'ouvertures (400) sont formées comme pluralité de trous ou pluralité de bandes.

8. Procédé de fabrication d'un transistor électroluminescent organique, le procédé comprenant :
la formation d'une électrode de grille (20) ;
la formation d'une couche d'isolation de grille (30) sur l'électrode de grille (20) ;
la formation d'une couche d'électrode ;
la formation d'un isolant de source (50) avec motifs sur la couche d'électrode ;
la structuration de la couche d'électrode en utilisant l'isolant de source (50) comme masque de gravure pour former une électrode de source de type maillé (40) comportant une pluralité d'ouvertures (400) selon un motif de réseau, dans lequel des parois latérales de l'électrode de source de type maillé (40) sont verticalement alignées sur des parois latérales de l'isolant de source (50) ;
la formation d'une couche semi-conductrice (60) sur la couche d'isolation de grille (30) et sur les parois latérales de l'électrode de source de type maillé (40) et de l'isolant de source (50) et la surface supérieure de l'isolant de source (50) ; et
la formation d'une couche électroluminescente organique (70) sur la couche semi-conductrice (60).

9. Procédé de fabrication d'un transistor électroluminescent organique selon la revendication 8, comprenant en outre :
la formation d'une électrode de drain (80) sur la couche électroluminescente organique (70).

10. Procédé de fabrication d'un transistor électroluminescent organique selon la revendication 8, dans lequel l'isolant de source (50) est composé d'une résine photosensible ; et
dans lequel ladite formation d'un isolant de source (50) comprend :
la formation d'une couche de résine photosensible sur la couche d'électrode ;
l'exposition d'une zone prédéterminée de la couche de résine photosensible à des rayons ultraviolets ; et
le retrait de la région exposée aux rayons ultraviolets de la couche de résine photosensible pour former l'isolant de source (50) avec motifs.

11. Procédé de fabrication d'un transistor électroluminescent organique selon la revendication 8, dans lequel chacune de la pluralité d'ouvertures (400) présente une largeur de 200 µm ou moins, et dans lequel un espace entre deux ouvertures voisines de la pluralité d'ouvertures (400) fait 200 µm ou moins.

12. Procédé de fabrication d'un transistor électroluminescent organique selon la revendication 8, dans lequel la pluralité d'ouvertures (400) sont formées comme pluralité de trous ou pluralité de bandes.
